# EUROPEAN PATENT SPECIFICATION

(11) **EP 2 171 758 B1**
(45) Date of publication and mention of the grant of the patent: **01.08.2012**
(21) Application number: 08835326.3
(22) Date of filing: 01.10.2008
(51) Int. Cl.: H01L 27/15, H01L 33/00

(54) **METHOD OF MANUFACTURING LIGHT-EMITTING DEVICE**
VERFAHREN ZUR HERSTELLUNG EINER LICHTEMITTIERENDEN VORRICHTUNG
PROCÉDÉ DE FABRICATION D'UN DISPOSITIF ÉLECTROLUMINESCENT

(30) Priority: 04.10.2007 JP 2007261018
(43) Date of publication of application: 07.04.2010
(73) Proprietor: Canon Kabushiki Kaisha, Tokyo 146-8501 (JP)
(72) Inventor: YONEHARA, Takao, Tokyo 146-8501 (JP)
(74) Representative: Weser, Wolfgang
(86) International application number: PCT/JP2008/068254
(87) International publication number: WO 2009/044923

(56) References cited:
- EP-A- 1 326 289
- WO-A-2007/133044
- WO-A-2008/050901
- US-A1- 2002 066 899

## Description

### TECHNICAL FIELD

The present invention relates to a method for manufacturing a light emitting device.

### BACKGROUND ART published

As is described in published Japanese Patent Application JP 2005-012034, a method is known which includes forming a compound semiconductor layer composing a light emitting device on a GaAs substrate through an AlAs layer, bonding the compound semiconductor layer with another substrate, separating the stack in the above described AlAs layer, and thereby transferring the compound semiconductor layer onto the substrate.

The document EP 1326289A2 similarly discloses a method of transferring a light-emitting semiconductor layer to a silicon substrate. However, various techniques have been required to be proposed for the transfer method.

Accordingly, the present invention is to provide a method for manufacturing a light emitting device, which includes such an easy, simple and new transfer method as not to have been seen in a conventional method.

### DISCLOSURE OF THE INVENTION

A method of manufacturing a light emitting device according to the present invention is characterized in that the method includes the steps of: preparing a first member which has an emission layer on a substrate having a compound semiconductor layer through an etch stop layer and a sacrifice layer; forming a bonded structure by bonding the first member on a second member including a silicon layer so that the emission layer is positioned in the inner side; providing a through groove in the substrate so that the etch stop layer is exposed, by dry-etching the first member from the reverse side of the emission layer; and removing the substrate having the through groove provided therein from the bonded structure by etching the sacrifice layer.

The present invention can provide a method for manufacturing a light emitting device, which includes such an easy, simple and new transfer method as not to have been seen in a conventional method.

Further features of the present invention will become apparent from the following description of exemplary embodiments with reference to the attached drawings.

### BRIEF DESCRIPTION OF THE DRAWINGS

FIG. 1 is a sectional view for describing the present invention.
FIGS. 2A and 2B are sectional views for describing the present invention.
FIG. 3 is a sectional view for describing the present invention.
FIG. 4 is a sectional view for describing the present invention.
FIG. 5 is a sectional view for describing the present invention.
FIG. 6 is a sectional view for describing the present invention.
FIG. 7 is a sectional view for describing the present invention.
FIG. 8 is a sectional view for describing the present invention.
FIG. 9 is a sectional view for describing the present invention.
FIG. 10 is a sectional view for describing the present invention.
FIG. 11 is a sectional view for describing the present invention.
FIG. 12 is a sectional view for describing the present invention.
FIG. 13 is a sectional view for describing the present invention.
FIG. 14 is a sectional view for describing the present invention.
FIG. 15 is a sectional view for describing the present invention.
FIG. 16 is a sectional view for describing the present invention.
FIG. 17 is a sectional view for describing the present invention.
FIG. 18 is a sectional view for describing the present invention.
FIG. 19 is a sectional view for describing the present invention.
FIG. 20 is a sectional view for describing the present invention.
FIG. 21 is a sectional view for describing the present invention.

### BEST MODES FOR CARRYING OUT THE INVENTION

A method for manufacturing a light emitting device according to the present invention will be now described with reference to the drawings.

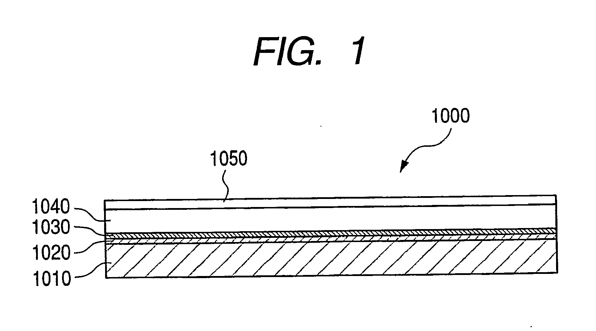

Firstly, a first member 1000 is prepared which has an emission layer 1040 on a substrate 1010 having a compound semiconductor layer through an etch stop layer 1020 and a sacrifice layer 1030, as is illustrated in FIG. 1. A semiconductor multilayer film 1050 (DBR mirror) can be provided on the emission layer as needed. The substrate 1010 having the compound semiconductor layer includes, for instance, a GaAs substrate. However, the present invention is not limited to the GaAs substrate, but various substrates can be applied as described later.

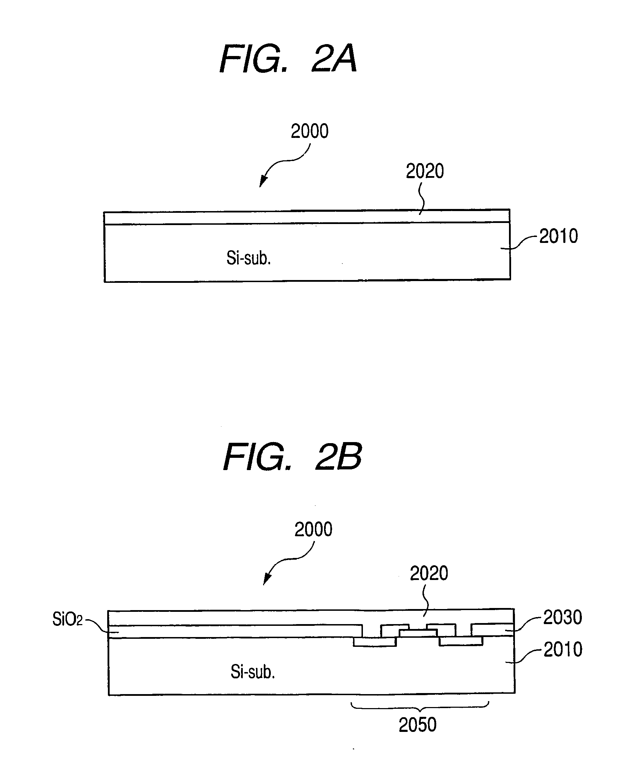

Subsequently, a second member 2000 is prepared which is illustrated in FIG. 2A. The second member is formed of a silicon wafer or a SOI wafer, for instance. In FIG. 2A, an organic insulation film 2020 is provided on a silicon layer 2010. In addition, FIG. 2B illustrates another example of the second member. FIG. 2B illustrates a second member 2000, a silicon layer 2010, an organic insulating layer 2020, an insulative oxide film 2030, and a region 2050 above which a driver circuit is provided. The above described silicon layer includes a silicon wafer, of course, or a SOI wafer, if the wafer would have a silicon layer.

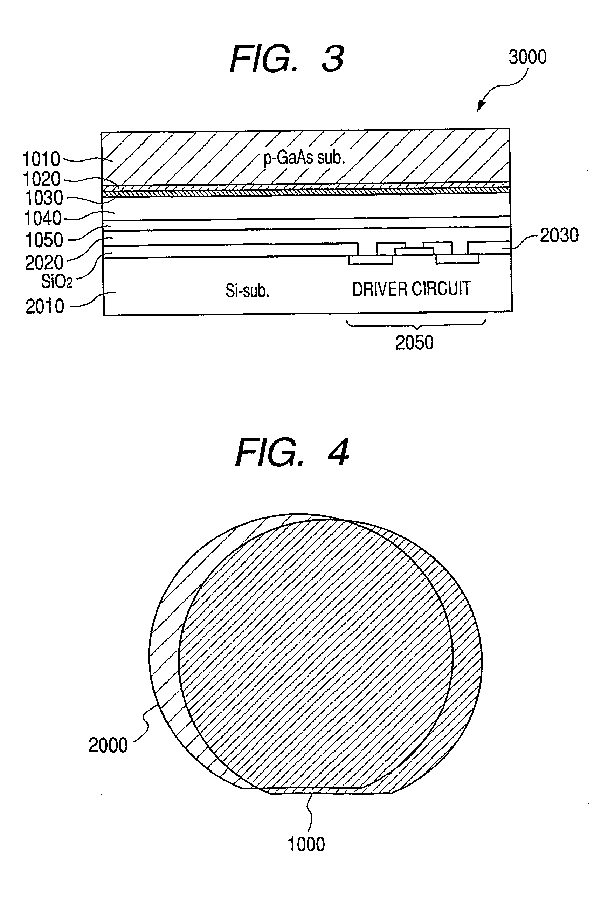

Then, the second member 2000 including the silicon layer 2010 and the above described first member 1000 are stacked so that the above described emission layer 1040 is positioned in the inner side to form a bonded structure 3000. This state is illustrated in FIG. 3. In addition, a state in which two members are stacked is illustrated in FIG. 4. In FIG. 3, the second member illustrated in FIG. 2B is used as a second member, but the second member of FIG. 2A can be used, of course, as well.

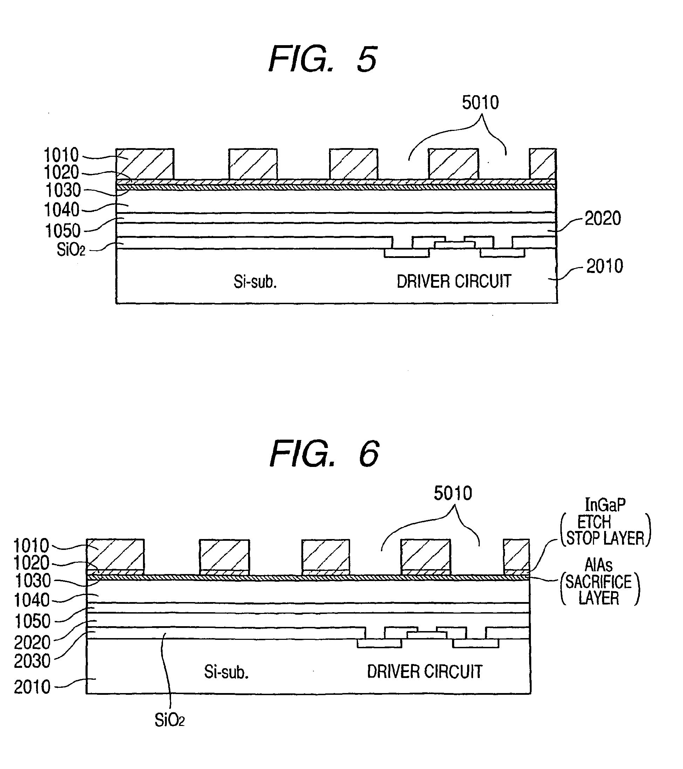

Subsequently, a through groove 5010 is provided on the substrate having the above described compound semiconductor layer so that the above described etch stop layer 1020 can be exposed, by dry etching the substrate 1010 having the above described compound semiconductor from the reverse side of the above described emission layer 1040 side, as is illustrated in FIG. 5.

A wet etching technique can also be employed instead of a dry etching technique for etching the substrate 1010. Furthermore, the through groove can also be formed by etching the substrate 1010 to some extent of depth with the dry etching technique, and switching the etching technique to the wet etching technique. In any case, the technique is not limited in particular, as long as the above described etch stop layer functions as an etch stop layer for the etching treatment when the substrate 1010 is etched from the back side.

When the above described through groove 5010 is provided, the through groove 5010 can be formed by thinning the substrate 1010 made from GaAs or the like (possibly to the thickness of 100 µm or less) beforehand, and then using a resist mask pattern.

The above described etch stop layer 1020 according to the present invention is characterized in that it is not used as a layer for stopping etching at a predetermined position when the first member is etched from the above described emission layer 1040 side towards the above described substrate 1010. That is to say, the etch stop layer 1020 is characterized in that it is used as a layer for stopping etching at a predetermined position when the first member is dry-etched from the above described substrate 1010 side towards the above described emission layer 1040.

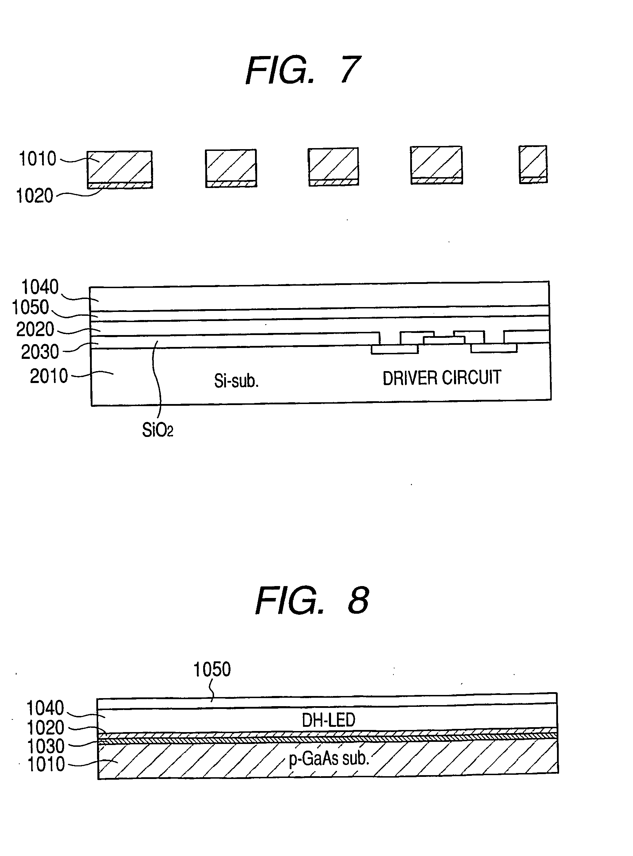

Furthermore, the above described sacrifice layer 1030 is exposed at the bottom part of the above described through groove (FIG. 6), and the substrate 1010 having the above described compound semiconductor layer, on which the above described through groove 5010 has been provided thereon is removed from the above described bonded structure, by wet etching the above described sacrifice layer (FIG. 7).

Thus, the emission layer 1040 is transferred onto a second member including a silicon layer.

### (First member)

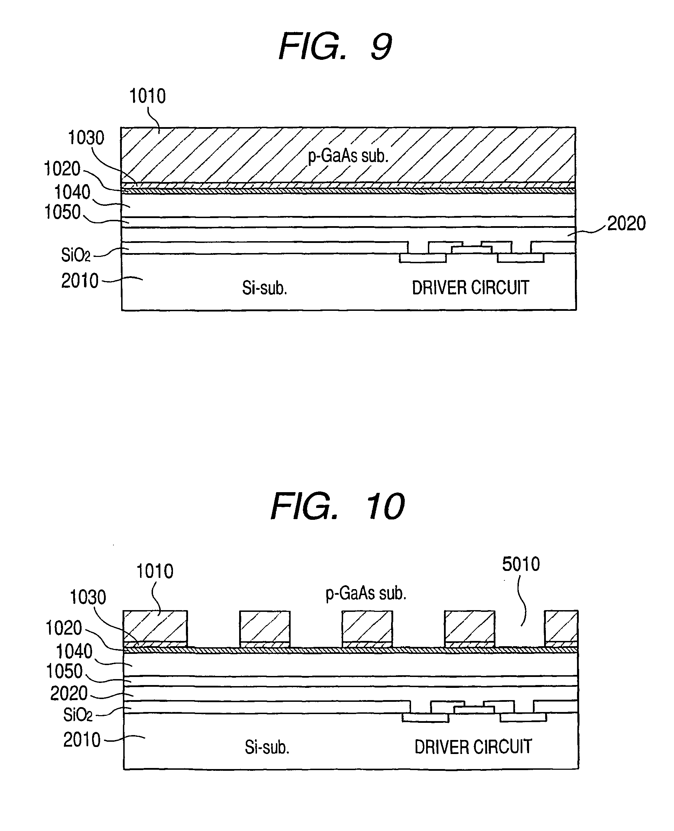

FIG. 1 describes a case in which the above described first member 1000 has the above described etch stop layer 1020 and the above described sacrifice layer 1030 in this order from the compound semiconductor layer side, on a substrate 1010 having the above described compound semiconductor layer. Practically, the first member can also include the above described sacrifice layer 1030 and the above described etch stop layer 1020 from the compound semiconductor layer 1010 side in this order, as is illustrated in FIG. 8. In such a case, a resultant bonded structure is illustrated in FIG. 9. When a substrate having the above described compound semiconductor layer is provided with a through groove and a through-hole by dry etching, the above described sacrifice layer 1030 is removed, and the above described etch stop layer 1020 results in being exposed, as is illustrated in FIG. 10. Afterward, the above described sacrifice layer 1030 is removed, and as a result, the substrate having the above described compound semiconductor layer is removed from the bonded structure.

When the above described etch stop layer remains on an emission layer 1040, the etch stop layer is appropriately removed. Thereby, the above described emission layer results in being transferred onto a second member, as is illustrated in FIG. 7.

The first member may have another layer in between the above described sacrifice layer and the above described etch stop layer, as long as the above described emission layer 1040 can be epitaxially grown on the substrate 1010 having the above described compound semiconductor layer.

The substrate having the above described compound semiconductor layer includes a GaAs substrate itself.

The substrate having the above described compound semiconductor layer also includes a sapphire substrate having a GaAs layer on the surface, a SiC substrate having a GaAs layer on the surface, or a ZnO substrate having a GaAs layer on the surface. A Ge substrate having a GaAs layer on the surface, and a Si substrate which has a GaAs layer on a Si wafer through a buffer layer can also be applied. Here, the substrate which has the GaAs layer on the Si wafer through the buffer layer is a substrate that has a Ge layer on the Si wafer through a SiGe layer and has the GaAs layer on the Ge layer.

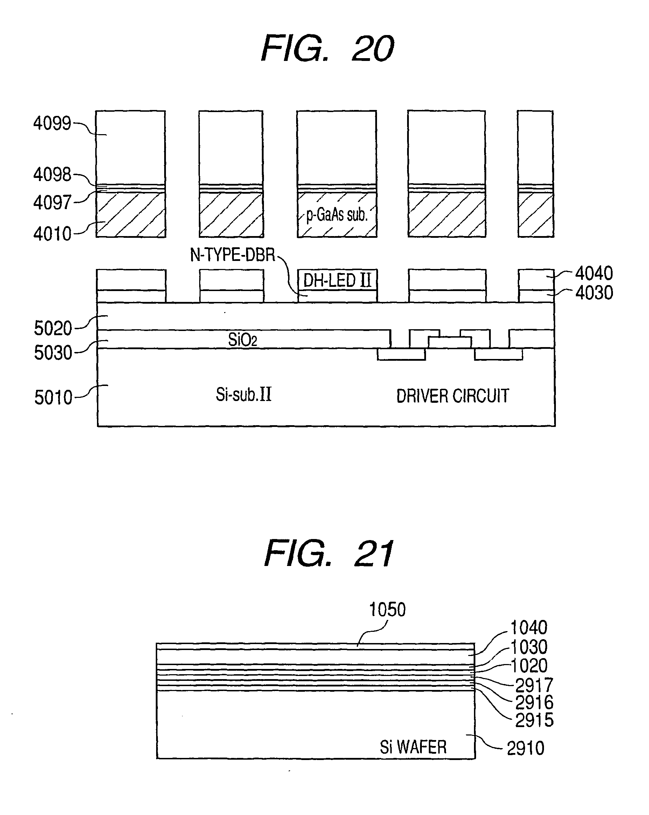

Here, FIG. 21 illustrates an example of the substrate having the above described compound semiconductor layer, which is formed by bonding the SiGe layer, the Ge layer and the GaAs layer in this order on the Si wafer. FIG. 21 illustrates the silicon wafer 2910, the SiGe layer 2915, the Ge layer 2916, and the GaAs layer 2917 which is not necessarily required. FIG. 21 also illustrates an etch stop layer 1020, a sacrifice layer 1030, an emission layer 1040 and a semiconductor multilayer film 1050 (DBR mirror). In addition, when a film of GaAs comprising an emission layer is formed on the Si wafer, the film is said to hardly acquire high quality because of lattice mismatch. In order to mitigate the lattice mismatch, the SiGe layer is provided on the Si wafer and the Ge layer is provided thereon. Thereby, a lattice constant of a film comprising the emission layer can be closer to that of its underlayer. The SiGe layer can set a value x of SiₓGe₁₋ₓ closer to 1 when the SiGe layer is close to a Si wafer side and decreases x as the SiGe layer gets away from the wafer, or in other words, can provide a gradient of a quantity of Ge.

Furthermore, a sapphire substrate, a SiC substrate and a ZnO substrate can also be used as the substrate having the above described compound semiconductor layer.

When the substrate having the above described compound semiconductor layer is a GaAs substrate, an etch stop layer is formed from GaInP (Ga_{0.5}In_{0.5}P, for instance). Of course, if a satisfactory selection ratio could be taken between materials of the substrate and the etch stop layer, the material of the etch stop layer is not limited in particular.

### (Emission layer)

The above described emission layer can employ a double heterostructure, and the detail will be described in an exemplary embodiment.

As has been already described, a semiconductor multilayer film mirror can also be provided on the above described emission layer.

### (Second member)

The above described second member can be provided with a driver circuit for driving the above described light emitting device, as has been already described.

The above described silicon layer comprising the above described second member can be provided with an organic insulating layer thereon which flattens the surface and functions as a bonding layer for the above described first member, but can also be omitted.

### (Mesa etching)

The method for producing the light emitting device has a step of etching the above described emission layer so that the emission layer can have a mesa structure, after the above described removal step.

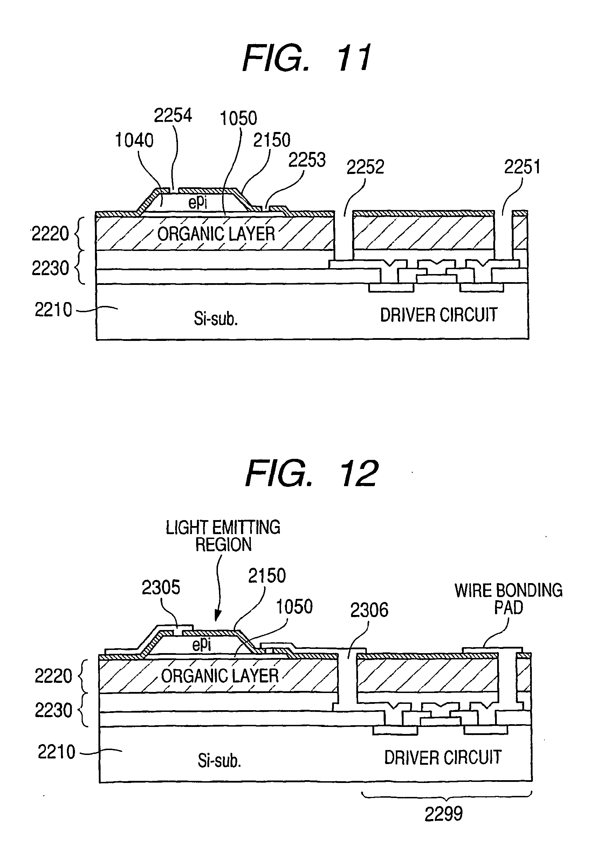

Specifically, an emission layer 1040 which has been transferred onto a second member is subjected to so-called mesa-etching treatment, an insulation film 2150 is formed on the emission layer 1040 having the mesa structure, and a pattern is formed thereon (FIG. 11). FIG. 11 illustrates a silicon wafer 2210, a passivation film 2230, an organic insulating layer 2220 and a semiconductor multilayer film 1050 which is provided on the emission layer. In FIG. 11, contact holes (2251 to 2254) for electrical connection are opened. Subsequently, metal thin films (2305 and 2306) are formed in the above described contact holes, and a driver circuit 2299 is electrically connected with the emission layer, as is illustrated in FIG. 12.

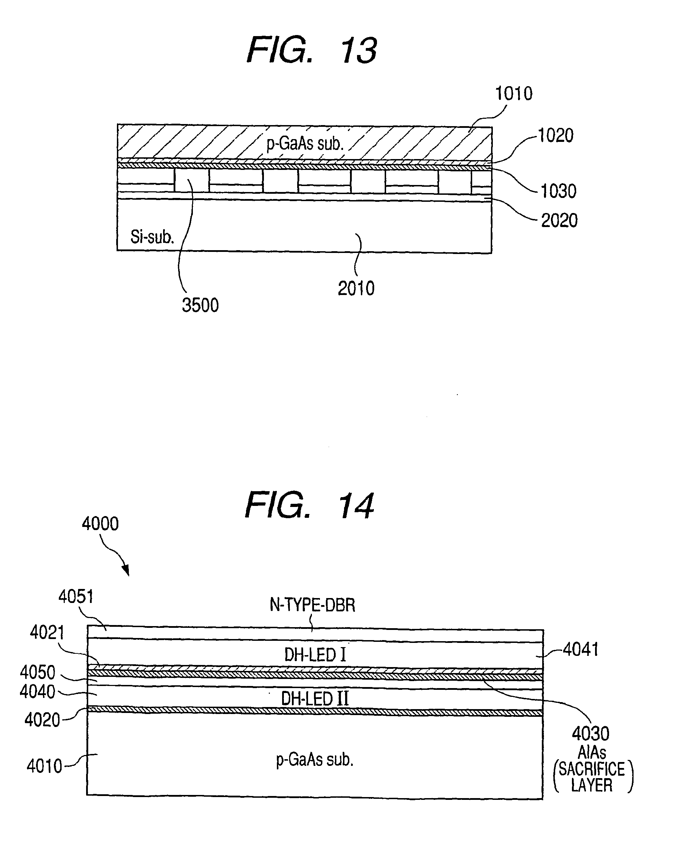

However, the above described bonded structure can also be formed after the above described emission layer has been etched into the mesa structure or an island form. In such a case, the obtained bonded structure has a cavity 3500 existing therein, as is illustrated in FIG. 13.

### (Multi)

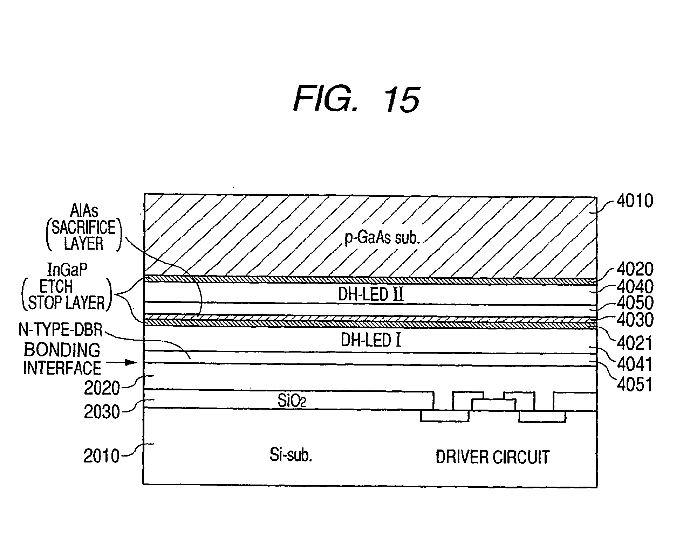

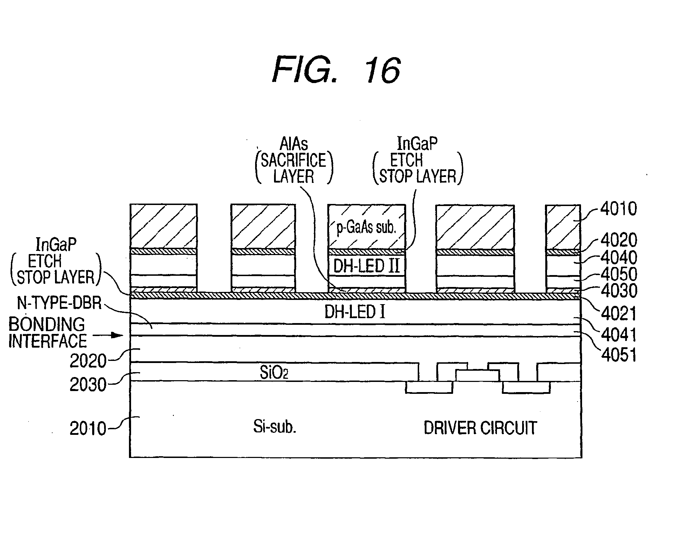

By the way, the above described first member can be configured so as to have the above described first etch stop layer 4020 formed on a substrate 4010 having the above described compound semiconductor layer, from the compound semiconductor layer side, and further have the above described first emission layer 4040, the above described sacrifice layer 4030, the above described second etch stop layer 4021, and the above described second emission layer 4041, as is illustrated in FIG. 14. Each of semiconductor multilayer films (DBR) 4050 and 4051 can be provided as needed. A bonded structure formed by providing a plurality of emission layers in this way is illustrated in FIG. 15. The substrate 4010 made from GaAs or the like is dry-etched from the back side with the use of a desired mask, as is illustrated in FIG. 16. Etching results in being stopped on the first etch stop layer 4020. After having been exposed, the layer is removed with a wet etching technique of using hydrochloric acid or the like. Then, the layers are further dry-etched towards an emission layer side until the second etch stop layer 4021 is exposed.

When a through groove is formed, the above described second etch stop layer 4021 is exposed, as is illustrated in FIG. 16.

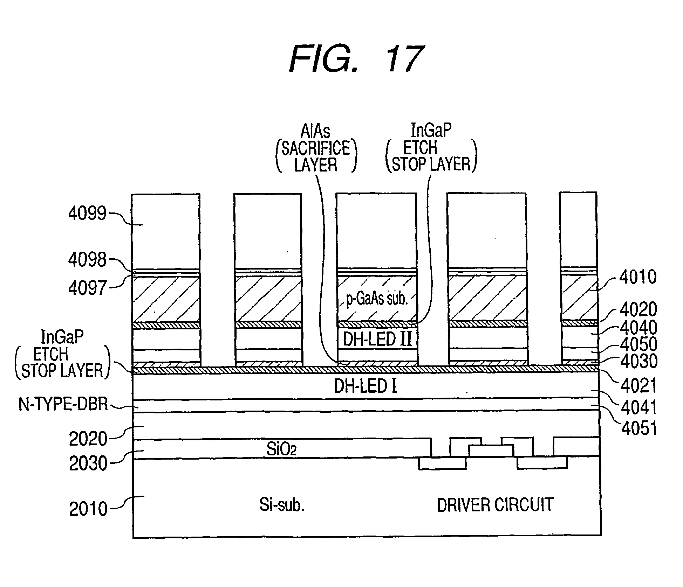

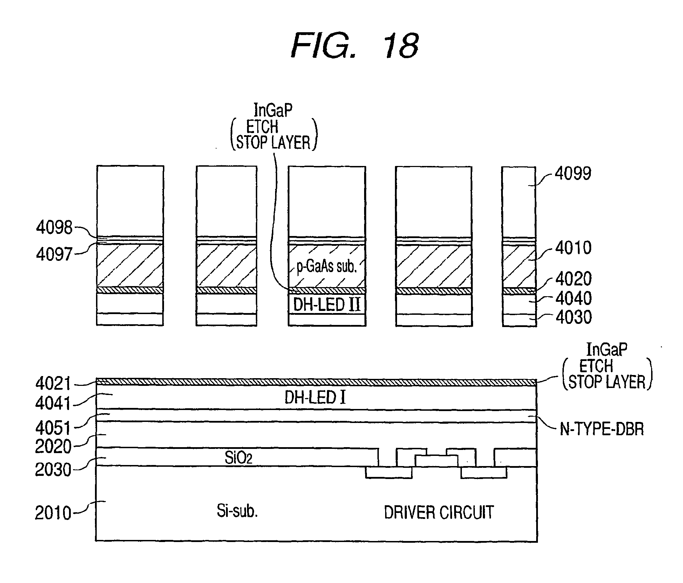

Specifically, a hole or a groove is provided on the substrate 4010 having the compound semiconductor layer with a dry etching technique to expose the above described first etch stop layer 4020, and the layer is removed with a wet etching technique. Subsequently, the through groove is further dug deeply with a dry etching technique until the above described second etch stop layer 4021 is exposed. The substrate 4010 having the above described compound semiconductor layer and the through groove formed therein is stacked with a glass support member 4099 having pores which link to the above described through groove, through an adhesive layer 4097 and a UV peeling layer 4098 (FIG. 17). A glass support member 4099 side is separated from the structure by removing the above described sacrifice layer 4030, as is illustrated in FIG. 18. When a GaAs substrate 4010 is thick, the substrate can be thinned (for instance, into the thickness of 100 µm or less) with a polishing or grinding technique such as CMP.

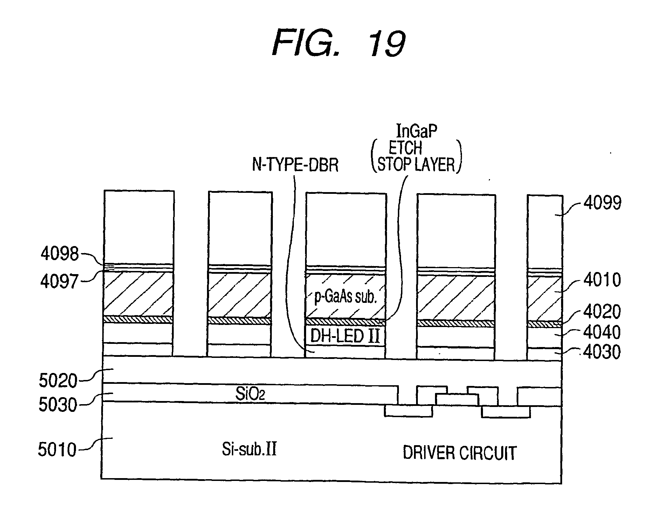

Subsequently, the glass support member 4099 side is further stacked with another substrate 5010 (for instance, silicon layer having driver circuit) so as to be transferred thereon, as is illustrated in FIG. 19. Then, the stacked material is separated into the glass support member 4099 side and the substrate 5010 side, by removing the above described first etch stop layer 4020, as is illustrated FIG. 20. After the emission layer 4040 has been transferred onto the substrate 5010, an electrode for injecting an electric current into the emission layer is provided in the layers with the above described process, and simultaneously the emission layer is electrically connected with the driver circuit.

The above described first member is formed so as to have the two following emission layers. Specifically, the first emission layer is the one provided on the above described substrate having the above described compound semiconductor layer through the above described first etch stop layer which acts as an etching stopper when the substrate is etched. The second emission layer is the one provided thereon through the above described sacrifice layer and the second etch stop layer.

Thus, the above described second emission layer results in being transferred onto the second member by removing the above described sacrifice layer.

In addition, the above described first emission layer can be transferred to another member by removing the above described first etch stop layer.

Here, the above described sacrifice layer is an AlAs layer, for instance, and the above described first etch stop layer and the above described second etch stop layer are made from GaInP, for instance.

In the above described invention, the first member can be temporarily stacked with a glass substrate or the like before being transferred to the second member, and finally can also be stacked with the second member.

### (Etching)

Gas species used when a through groove is formed in a substrate constituting the above described first member with a dry etching technique (RIBE) include Cl₂, SiCl₄ or the like as a chlorine-based gas. A mixture gas of the chlorine-based gas and an inert gas such as Ar can also be used. N₂ gas, O₂ gas, CO gas or the like can also be applied as an additive gas. An etch stop layer made from AlInP, for instance, other than GaInP can also be used as the etch stop layer for dry etching.

When the above described through groove is prepared with a wet etching technique, the operation is conducted in the following way. For instance, when GaInP is used as the etch stop layer, and a GaAs substrate is etched, a sulfuric-acid-based or phosphoric-acid-based solution (in which hydrogen peroxide water is contained) is used as an etching solution. On the other hand, when an InP-based substrate is employed and GaAs or the like is used as the etch stop layer, a chlorine-based etching solution is used.

### (Exemplary embodiments)

At first, a p-type GaAs substrate 1010 is prepared for producing a first member, as is illustrated in FIG. 1. The GaAs substrate corresponds to the already described substrate having the compound semiconductor layer.

An InGaP layer is formed into 100 nm thereon as an etch stop layer 1020, with a MOCVD technique. A p-AlAs layer 1030 is further formed thereon into 100 nm as a sacrifice layer. Alternatively, the etch stop layer can be formed into a thickness in a range of several nanometers to several tens of nanometers.

An emission layer 1040 includes a p-type contact layer (GaAs), a p-type clad layer, a p-type active layer, an n-type clad layer, an n-type contact layer (GaAs) and an n-stop layer (Ga_{0.5}In_{0.5}P), from a substrate 1010 side. The n-stop layer is a layer for stopping mesa-etching after the emission layer has been transferred.

The p-type clad layer is made from p-Al_{0.4}Ga_{0.6}As with the thickness of 350 nm.

The p-type active layer which works as an active layer is p-Al_{0.13}Ga_{0.87}As with the thickness of 300 nm. The n-type clad layer is n-Al_{0.23}Ga_{0.77}As with the thickness of 1,300 nm. Both of the p-type contact layer and the n-type contact layer have the thickness of 200 nm.

In addition, an n-type DBR layer (1050 of FIG. 1) includes 20 pairs of Al_{0.2}Ga_{0.8}As with the thickness of 633 angstrom and Al_{0.8}Ga_{0.2}As with the thickness of 565 angstrom which are stacked.

A second member 2000 (FIGS. 2A and 2B) is provided with an organic insulation film which can be applied smoothly on a silicon layer with a spin coating method and is a polymer film that is not etched when the sacrifice layer is selectively etched. A polyimide film having a thickness of 2 µm can be used as the organic insulation film, which is prepared by spin-coating polyimide dissolved in a solvent and vaporizing the solvent.

In a bonding step (FIG. 3), the organic insulation film is exposed to plasma of nitrogen, oxygen, Ar or the like so that the surface is activated, and is subjected to low-temperature heat treatment at 400°C or lower (at 280°C for 2 hours, for instance) after a bonding operation. When the member has a driving device such as a silicon transistor in its lower part, it is essential to stack the members at a low temperature. If the members would be treated at a high temperature, impurities in a silicon device are diffused again, and it is likely that the device is not operated normally.

After the bonding step, a resist mask is applied to the back side of a GaAs substrate and is exposed to light to have a desired opening formed at a desired position, and a through groove (5010 of FIG. 5) is formed with a dry etching technique of ICP-RIE with the use of a capacitive coupled plasma apparatus, as is illustrated in FIG. 5. Before a resist film for dry etching is applied, the GaAs substrate is preferably thinned with a CMP technique or the like. As for a RIE condition, a substrate temperature is approximately 100°C and chlorine is used for a reactive gas. The exemplary embodiment utilizes a phenomenon that etching is stopped on the above described etch stop layer InGaP 1020 when the substrate has been subjected to the above described dry etching treatment.

Subsequently, an InGaP etch stop layer is removed by using HCl to make an AlAs sacrifice layer exposed. The AlAs layer which is a sacrifice layer in the member is removed by selective etching with the use of diluted HF, and the GaAs substrate is separated from a bonded structure. The AlAs layer can be removed by using 5% hydrofluoric acid solution.

Subsequently, the emission layer 1040 which has been transferred onto the silicon layer is etched into a mesa structure, and a SiN film 2150 is formed thereon with a plasma CVD technique, as is illustrated in FIGS. 11 and 12. Then, a SiN film is patterned, a contact hole 2251 or the like is formed, metals such as Ni/Au are vapor-deposited, and the emission layer (light emitting diode) is electrically connected with a driver circuit 2299. When the emission layer is connected with the driver circuit, the semiconductor multilayer film of FIG. 11 may be configured as an n-type DBR. Then, the driver circuit can be electrically connected with the n-type DBR layer. When the member is thus configured, the member does not need to inject a carrier toward all film thickness directions of the DBR from an n-side electrode, and can avoid the need of high resistance.

By using a method for manufacturing a light emitting device according to the present invention, the light emitting device can be formed into an arrayed shape on a silicon layer. The light emitting device having the arrayed shape can constitute a printer head of an LED printer.

## Claims

1. A method of manufacturing a light emitting device comprising the steps of:
preparing a first member (1000) which has an emission layer (1040) on a substrate (1010) having a compound semiconductor layer through an etch stop layer (1020) and a sacrifice layer (1030);
forming a bonded structure by bonding the first member on a second member (200) including a silicon layer so that the emission layer is positioned in the inner side;
providing a through grooved (5010) in the substrate so that the etch stop layer is exposed, by etching the first member from the reverse side of the emission layer; and
removing the substrate having the through groove provided therein from the bonded structure by etching the sacrifice layer.

2. The method for manufacturing the light emitting device according to claim 1, wherein the first member has the etch stop layer and the sacrifice layer on the substrate having the compound semiconductor layer, in this order from the substrate side.

3. The method for manufacturing the light emitting device according to claim 1, wherein the first member has the sacrifice layer and the etch stop layer on the substrate having the compound semiconductor layer, in this order from the substrate side.

4. The method for manufacturing the light emitting device according to claim 1, wherein the substrate having the compound semiconductor layers includes a GaAs substrate, a sapphire substrate having a GaAs layer on the surface, a SiC substrate having a GaAs layer on the surface, a ZnO substrate having a GaAs layer on the surface, a Ge substrate having a GaAs layer on the surface, or a Si substrate having a GaAs layer on a Si wafer through a buffer layer.

5. The method for manufacturing the light emitting device according to claim 4, wherein the substrate having the GaAs layer on the Si wafer through the buffer layer is a substrate which has a Ge layer on the Si wafer through a SiGe layer and has the GaAs layer on the Ge layer.

6. The method for manufacturing the light emitting device according to claim 1, wherein the emission layer has a semiconductor multilayer mirror thereon.

7. The method for manufacturing the light emitting device according to claim 1, wherein the second member has a driver circuit for driving the light emitting device provided therein.

8. The method for manufacturing the light emitting device according to claim 1, wherein the silicon layer included in the second member has an organic insulating layer provided thereon.

9. The method for manufacturing the light emitting device according to claim 1, further comprising a step of etching the emission layer into a mesa structure after the removal.

10. The method for manufacturing the light emitting device according to claim 1, further comprising forming the bonded structure after having etched the emission layer into a mesa structure.

11. The method for manufacturing the light emitting device according to claim 1, wherein the first member has the first etch stop layer, the first emission layer, the sacrifice layer, a second etch stop layer and a second emission layer on the substrate having the compound semiconductor layer from the compound semiconductor layer side.

12. The method for manufacturing the light emitting device according to claim 1, wherein the first member comprises
the first emission layer on the substrate having the compound semiconductor layer through the first etch stop layer which acts as an etching stopper when the substrate is etched, and
a second emission layer through the sacrifice layer and a second etch stop layer; and **characterized by**
transferring the second emission layer onto a second member by removing the sacrifice layer, and
transferring the first emission layer onto another member by removing the first etch stop layer.

13. The method for manufacturing the light emitting device according to claim 12, wherein the sacrifice layer is an AlAs layer, and the first etch stop layer and the second etch stop layer are made from GaInP.

## Patentansprüche

1. Verfahren zur Herstellung einer lichtemittierenden Vorrichtung, umfassend die Schritte:
Präparieren eines ersten Gliedes (1000), welches vorliegt als eine Emissionsschicht (1040) auf einem Substrat (1010), das eine Verbindungshalbleiterschicht via einer Ätzstoppschicht (1020) sowie eine Opferschicht (1030) hat;
Ausbilden einer gebondeten Struktur durch Bonden des ersten Gliedes auf ein zweites Glied (2000), beinhaltend eine Siliciumschicht, so, dass die Emissionsschicht sich auf der Innenseite befindet;
Vorsehen einer Durchgangsnut (5010) im Substrat derart, dass die Ätzstoppschicht freiliegt, indem das erste Glied von der Rückseite der Emissionsschicht her geätzt wird; und
Entfernen des Substrats mit der darin befindlichen durchgehenden Nut von der gebondeten Struktur durch Ätzen der Opferschicht.

2. Verfahren nach Anspruch 1, wobei
das erste Glied die Ätzstoppschicht sowie die Opferschicht auf dem Substrat, die die Verbindungshalbleiterschicht hat, in dieser Reihenfolge von der Substratseite aus aufweist.

3. Verfahren nach Anspruch 1, wobei
das erste Glied die Opferschicht und die Ätzstoppschicht auf dem Substrat, die die Verbindungshalbleiterschicht hat, in dieser Reihenfolge von der Substratseite aus hat.

4. Verfahren nach Anspruch 1, wobei
das Substrat, das die Verbindungshalbleiterschichten hat, ein GaAs-Substrat, ein Saphir-Substrat mit einer GaAs-Schicht auf der Oberfläche, ein SiC-Substrat mit einer GaAs-Schicht auf der Oberfläche, ein ZnO-Substrat mit einer GaAs-Schicht auf der Oberfläche, ein Ge-Substrat mit einer GaAs-Schicht auf der Oberfläche, oder ein Si-Substrat mit einer GaAs-Schicht auf einem Si-Wafer mit dazwischen befindlicher Pufferschicht beinhaltet.

5. Verfahren nach Anspruch 4, wobei
das Substrat mit der GaAs-Schicht auf dem Si-Wafer mit dazwischen liegender Pufferschicht ein Substrat ist, welches eine Ge-Schicht auf dem Si-Wafer via einer SiGe-Schicht hat und die GaAs-Schicht auf der Ge-Schicht hat.

6. Verfahren nach Anspruch 1, wobei
die Emissionsschicht einen auf ihr befindlichen mehrschichtigen Halbleiterspiegel aufweist.

7. Verfahren nach Anspruch 1, wobei
das zweite Glied eine Treiberschaltung zum Treiben der darin vorgesehenen Lichtemissionsvorrichtung enthält.

8. Verfahren nach Anspruch 1, wobei
die in dem zweiten Glied inkludierte Siliciumschicht eine darauf befindliche organische Isolierschicht hat.

9. Verfahren nach Anspruch 1, weiterhin umfassend:
einen Schritt zum Ätzen der Emissionsschicht in eine Mesastruktur nach dem Entfernen.

10. Verfahren nach Anspruch 1, weiterhin umfassend:
das Ausbilden der gebondeten Struktur, nach dem Ätzen der Emissionsschicht in eine Mesastruktur.

11. Verfahren nach Anspruch 1, wobei
das erste Glied die erste Ätzstoppschicht, die erste Emissionsschicht, die Opferschicht, eine zweite Ätzstoppschicht und eine zweite Emissionsschicht auf dem Substrat, das die Verbindungshalbleiterschicht hat, und zwar ausgehend von der Verbindungshalbleiterschichtseite hat.

12. Verfahren nach Anspruch 1,
bei dem das erste Glied umfasst:
die erste Emissionsschicht auf dem Substrat, das die Verbindungshalbleiterschicht via der ersten Ätzstoppschicht hat, welche als Ätzstopper fungiert, wenn das Substrat geätzt wird, und
eine zweite Emissionsschicht via der Opferschicht und der zweiten Ätzstoppschicht,
**gekennzeichnet durch**
Transferieren der zweiten Emissionsschicht auf ein zweites Glied durch Entfernen der Opferschicht, und
Transferieren der ersten Emissionsschicht auf ein weiteres Glied **durch** Entfernen der ersten Ätzstoppschicht.

13. Verfahren nach Anspruch 12, wobei
die Opferschicht vorliegt als eine AlAs-Schicht und die erste und zweite Ätzstoppschicht aus GaInP hergestellt sind.

## Revendications

1. Procédé de fabrication d'un dispositif électroluminescent, comprenant les étapes consistant à :
préparer un premier élément (1000) comportant une couche émettrice (1040) sur un substrat (1010) portant une couche semiconductrice composite avec interposition d'une couche d'arrêt de gravure (1020) et d'une couche sacrificielle (1030) ;
former une structure collée en collant le premier élément sur un second élément (2000) comprenant une couche de silicium, si bien que la couche émettrice est placée sur le côté intérieur ;
réaliser une rainure profonde (5010) au travers du substrat, si bien que la couche d'arrêt de gravure est exposée, en gravant le premier élément par le côté opposé à la couche émettrice ; et
retirer le substrat comportant la rainure profonde de la structure collée en gravant la couche sacrificielle.

2. Procédé de fabrication du dispositif électroluminescent selon la revendication 1, dans lequel le premier élément possède la couche d'arrêt de gravure et la couche sacrificielle sur le substrat portant la couche semiconductrice composite, dans cet ordre à partir de la face du substrat.

3. Procédé de fabrication du dispositif électroluminescent selon la revendication 1, dans lequel le premier élément possède la couche sacrificielle et la couche d'arrêt de gravure sur le substrat portant la couche semiconductrice composite, dans cet ordre à partir de la face du substrat.

4. Procédé de fabrication du dispositif électroluminescent selon la revendication 1, dans lequel le substrat portant les couches semiconductrices composites peut être un substrat de GaAs, un substrat de saphir portant une couche de GaAs à sa surface, un substrat de SiC portant une couche de GaAs à sa surface, un substrat de ZnO portant une couche de GaAs à sa surface, un substrat de Ge portant une couche de GaAs à sa surface ou un substrat de Si portant une couche de GaAs à sa surface, placé sur une tranche de Si avec interposition d'une couche tampon.

5. Procédé de fabrication du dispositif électroluminescent selon la revendication 4, dans lequel le substrat portant la couche de GaAs placé sur une tranche de Si avec interposition de la couche tampon est un substrat qui a une couche de Ge sur la tranche de Si, avec interposition d'une couche de SiGe, la couche de GaAs étant placée sur la couche de Ge.

6. Procédé de fabrication du dispositif électroluminescent selon la revendication 1, dans lequel la couche émettrice porte un miroir semiconducteur à couches multiples.

7. Procédé de fabrication d'un dispositif électroluminescent selon la revendication 1, dans lequel le second élément possède un circuit d'attaque pour commander le dispositif électroluminescent fourni.

8. Procédé de fabrication du dispositif électroluminescent selon la revendication 1, dans lequel la couche de silicium incluse dans le second élément porte une couche d'isolation organique qui y est déposée.

9. Procédé de fabrication du dispositif électroluminescent selon la revendication 1, comprenant en outre une étape consistant à graver la couche émettrice pour donner une structure en mesa après l'élimination.

10. Procédé de fabrication du dispositif électroluminescent selon la revendication 1, comprenant en outre l'étape consistant à former la structure collée après avoir gravé la couche émettrice pour donner une structure en mesa.

11. Procédé de fabrication du dispositif électroluminescent selon la revendication 1, dans lequel le premier élément porte la première couche d'arrêt de gravure, la première couche émettrice, la couche sacrificielle, une seconde couche d'arrêt de gravure et une seconde couche émettrice sur le substrat portant la couche semiconductrice composite, à partir du côté de la couche semiconductrice composite.

12. Procédé de fabrication d'un dispositif électroluminescent selon la revendication 1, dans lequel le premier élément comprend :
la première couche émettrice sur le substrat portant la couche semiconductrice composite, avec interposition de la première couche d'arrêt de gravure qui assure la fonction d'arrêt de la gravure lorsque le substrat est gravé ; et
une seconde couche émettrice avec interposition de la couche sacrificielle et une seconde couche d'arrêt de gravure ;
**caractérisé par** les étapes consistant à :
transférer la seconde couche émettrice sur un second élément en éliminant la couche sacrificielle ; et
transférer la première couche émettrice sur un autre élément en éliminant la première couche d'arrêt de gravure.

13. Procédé de fabrication du dispositif électroluminescent selon la revendication 12, dans lequel la couche sacrificielle est une couche d'AlAs et la première couche d'arrêt de gravure et la seconde couche d'arrêt de gravure sont faites de GaInP.
